# EUROPEAN PATENT APPLICATION

(11) **EP 4 513 575 A1**
(43) Date of publication of application: **26.02.2025**
(21) Application number: 22938350.0
(22) Date of filing: 23.12.2022
(51) Int. Cl.: H01L 31/0236

(54) **SOLAR CELL AND MANUFACTURING METHOD THEREFOR**

(30) Priority: 20.04.2022 CN 202210414997
(71) Applicant: Tongwei Solar (Chengdu) Co., Ltd., Chengdu, Sichuan 610299 (CN)
(72) Inventor: FAN, Jianbin, Meishan, Sichuan 620041 (CN); MENG, Xiajie, Meishan, Sichuan 620041 (CN); XING, Guoqiang, Meishan, Sichuan 620041 (CN)
(74) Representative: Michalski Hüttermann & Partner Patentanwälte mbB
(86) International application number: PCT/CN2022/141300
(87) International publication number: WO 2023/202132

(57) **Abstract**

The present application relates to a manufacturing method for a solar cell, including the following steps: providing a P-type silicon wafer, the P-type silicon wafer being provided with a first surface and a second surface opposite to the first surface; sequentially depositing an oxide layer, a doped amorphous silicon film layer, and a silicon oxide mask layer on the first surface of the P-type silicon wafer; and removing the oxide layer, the doped amorphous silicon film layer, and the silicon oxide mask layer coated on the second surface. According to the manufacturing method, the surface texture uniformity of the front surface of a cell piece is can be further effectively improved, and the appearance of the front surface of the cell is improved, and thus, the cell efficiency and the product yield of the solar cell are improved. The present application relates to a corresponding solar cell.

## Description

### CROSS-REFERENCE TO RELATED APPLICATION

This application claims priority to Chinese patent application No. 202210414997.X, filed on April 20, 2022, and titled "P-TYPE BACK CONTACT CELL AND MANUFACTURING METHOD THEREOF", the content of which is hereby incorporated by reference in its entirety.

### TECHNICAL FIELD

The present application relates to the field of solar cell manufacturing technology, in particular, to a solar cell and a manufacturing method thereof.

### BACKGROUND

Back contact cells includes interdigitated back contact cells, which is also called IBC cell. The most important feature of the IBC cell is that a PN junction region or PN junction-like region as well as the metal electrodes are disposed on the back surface of the cell, and the front surface of the cell is free from the effects of metal electrode shading.

Due to the above structural characteristics of the IBC cells, the IBC cells have higher short-circuit current *Jsc.* At the same time, the back surface of the IBC cells can accommodate wider metal grid lines to reduce the series resistance *Rs* and thus improve the filling factor FF. In addition, the IBC cells without shading at the front surface not only have high conversion efficiency, but also look more aesthetically pleasing. Therefore, the IBC cells have become one of the current technological directions for realizing high-efficiency crystalline silicon cells.

However, the current P-type back contact cells are prone to surface texture uniformity and poor frontal appearance on the front surface of the cell after texturing. The back contact cell is an appearance-type battery product, and a poor frontal appearance will greatly affect the yield of the product; and the surface texture nonuniformity on the front surface will also lead to a high localized reflectivity, which affects the cell current, and thus affects the efficiency of the cell.

### SUMMARY

In view of above, it is necessary to provide a solar cell capable of improving surface texture uniformity on the front surface of the cell and improving the appearance of the front surface of the cell and a manufacturing method thereof, so as to solve the problem of surface texture nonuniformity and poor appearance of the front surface of the textured cell.

In order to solve the technical problem above, the present disclosure provides following technical proposals.

In an aspect of the present disclosure, a method for manufacturing a solar cell is provided, including the following steps:
providing a P-type silicon wafer, wherein the P-type silicon wafer includes a first surface and a second surface opposite to the first surface;
sequentially depositing an oxide layer, a doped amorphous silicon film layer, and a silicon oxide mask layer on the first surface of the P-type silicon wafer; and
removing the oxide layer, the doped amorphous silicon film layer, and the silicon oxide mask layer wraparound deposited on the second surface of the P-type silicon wafer.

In some embodiments, the step of removing the oxide layer, the doped amorphous silicon film layer, and the silicon oxide mask layer wraparound deposited on the second surface of the P-type silicon wafer further includes: removing the oxide layer, the doped amorphous silicon film layer, and the silicon oxide mask layer wraparound deposited on the second surface of the P-type silicon wafer by a mixed solution containing hydrofluoric acid and nitric acid.

In some embodiments, the step of removing the oxide layer, the doped amorphous silicon film layer, and the silicon oxide mask layer wraparound deposited on the second surface of the P-type silicon wafer further includes the following steps:
coating a protective film on the first surface of the P-type silicon wafer, and
etching the second surface of the P-type silicon wafer with the mixed solution containing the hydrofluoric acid and the nitric acid, so as to remove the oxide layer, the doped amorphous silicon film layer, and the silicon oxide mask layer wraparound deposited on the second surface of the P-type silicon wafer.

In some embodiments, after the step of depositing the oxide layer, the doped amorphous silicon film layer, and the silicon oxide mask layer on the first surface of the P-type silicon wafer, the manufacturing method further includes the following steps,
removing the oxide layer, the doped amorphous silicon film layer, and the silicon oxide mask layer wraparound deposited on the side surface of the P-type silicon wafer by the mixed solution containing the hydrofluoric acid and the nitric acid.

In some embodiments, in the mixed solution containing the hydrofluoric acid and the nitric acid, a volume percentage of the hydrofluoric acid is in a range of 10% to 30%, and a volume percentage of the nitric acid is in a range of 50% to 80%.

In some embodiments, the mixed solution containing the hydrofluoric acid and the nitric acid further includes a sulfuric acid, and a volume percentage of the sulfuric acid is in a range of 10% to 25%.

In some embodiments, depositing the oxide layer on the first surface of the P-type silicon wafer further includes: depositing the oxide layer on the first surface of the P-type silicon wafer by a plasma enhanced chemical vapor deposition method, a thermal oxidation method or a chain oxidation method.

In some embodiments, depositing the doped amorphous silicon film layer and the silicon oxide mask layer on the first surface of the P-type silicon wafer further includes: depositing the doped amorphous silicon film layer and the silicon oxide mask layer on the first surface of the P-type silicon wafer by a plasma enhanced chemical vapor deposition method.

In some embodiments, the oxide layer is a silicon oxide layer, and a thickness of the oxide layer is in a range of 0.5 nm to 2.5 nm;

In some embodiments, a thickness of the doped amorphous silicon film layer is in a range of 30 nm to 300 nm.

In some embodiments, a thickness of the silicon oxide mask layer is in a range of 10 nm to 100nm.

In some embodiments, after the step of depositing the silicon oxide mask layer, and before the step of removing the oxide layer, the doped amorphous silicon film layer and the silicon oxide mask layer wraparound deposited on the second surface of the P-type silicon wafer, the manufacturing method further includes a step of subjecting the P-type silicon wafer to an annealing process, so as to transform the doped amorphous silicon film layer to a doped polycrystalline silicon film layer and make the silicon oxide mask layer densified.

In some embodiments, a temperature of the annealing process is in a range of 800 °C to 950 °C, and a time of the annealing process is in a range of 30 min to 50 min, so as to form a silicon oxide mask layer on an outermost side of the P-type silicon wafer.

In some embodiments, after the step of removing the oxide layer, the doped amorphous silicon film layer, and the silicon oxide mask layer wraparound deposited on the second surface of the P-type silicon wafer, the manufacturing method further includes a step of single-sided texturing the second surface of the P-type silicon wafer.

In some embodiments, after the step of single-sided texturing the second surface of the P-type silicon wafer, the manufacturing method further includes a step of subjecting the second surface of the P-type silicon wafer to a thermal oxidation process.

In some embodiments, after subjecting the second surface of the P-type silicon wafer to the thermal oxidation process, the manufacturing method further includes a following step:
subjecting the silicon oxide mask layer on the first surface of the P-type silicon wafer to patterning treatment by laser, so as to remove a part of the silicon oxide mask layer to form a patterning region.

In some embodiments, after forming the patterning region, the manufacturing method further includes a following step:
etching the P-type silicon wafer with an alkali solution, so as to remove the oxide layer and the doped polycrystalline silicon film layer in the patterning region.

In some embodiments, after the etching the P-type silicon wafer with the alkali solution, the manufacturing method further includes: depositing passivating film layers on the first surface of the P-type silicon wafer and the second surface of the P-type silicon wafer, respectively.

In some embodiments, after depositing the passivating film layers on the first surface of the P-type silicon wafer and the second surface of the P-type silicon wafer respectively, the manufacturing method further includes a step of depositing antireflection film layers on the first surface of the P-type silicon wafer and the second surface of the P-type silicon wafer, respectively.

In some embodiments, the passivating film layers are aluminum oxide layers and thicknesses of the passivating film layers are in a range of 2 nm to 25 nm.

In some embodiments, the antireflection film layers are made of materials selected from the group consisting of silicon nitride, silicon nitride oxide, silicon oxide, and any combinations thereof, and thicknesses of the antireflection film layers are in a range of 50 nm to 150 nm.

In some embodiments, after the step of depositing the antireflection film layers on the first surface of the P-type silicon wafer and the second surface of the P-type silicon wafer respectively, the manufacturing method further includes following steps:
forming holes in the patterning region on the first surface of the P-type silicon wafer by laser, so as to remove the passivating film layer and the antireflection film layer at the holes to form an electrode contact region; and
filling electrode slurry in the electrode contact region and the doped polycrystalline silicon film layer to form the first electrode and the second electrode, respectively.

In another aspect of the present disclosure, a solar cell is provided, and the solar cell is manufactured by the method described above.

In the method described above, after depositing an ultrathin oxide layer, an ultrathin doped amorphous silicon film layer and an ultrathin silicon oxide mask layer on the first surface of the P-type silicon wafer, the oxide layer, the doped amorphous silicon film layer and the silicon oxide mask layer wraparound deposited on the second surface of the P-type silicon wafer are removed, so as to effectively improve surface texture uniformity of the front surface of the cell and improve appearance of the front surface of the cell; so that the cell efficiency and the product yield of the solar cell are improved.

In addition, sequentially depositing the doped amorphous silicon film layer and the silicon oxide mask layer on the oxide layer by a plasma enhanced chemical vapor deposition method, and subjecting the P-type silicon wafer to a thermal oxidation method, the doped amorphous silicon film layer is transformed to polycrystalline silicon to form a doped polycrystalline silicon film layer, and make the silicon oxide mask layer densified at the same time. Thus, alkali resistance of the P-type silicon wafer can be improved, protective effect of the silicon oxide mask layer to the PN junction region in the following texturing process is improved, so as to prolong a time window of the following texturing process. Due to thermal oxidation process of the silicon oxide mask layer, the density of the silicon oxide mask layer is improved, and the alkali resistance of the silicon oxide mask layer is improved.

### BRIEF DESCRIPTION OF THE DRAWINGS

One or more of the accompanying drawings may be referred to in order to better describe and illustrate the embodiments and/or examples of the present application. The additional details or examples used to describe the accompanying drawings should not be considered a limitation on the scope of any of the disclosed applications, the embodiments and/or examples currently described, and the best mode of these applications as currently understood.
FIG. 1 is a structural schematic diagram of a P-type back contact solar cell in one embodiment of the present disclosure.
FIG. 2 is a bottom view of FIG. 1.
FIG. 3 is a structural schematic diagram of a P-type silicon wafer.
FIG. 4 is a structural schematic diagram of the P-type silicon wafer, in which the oxide layer, the doped amorphous silicon film layer and the silicon oxide mask layer are wrapped and coated on the side surface of the P-type silicon wafer and the front surface of the P-type silicon wafer.
FIG. 5 is a structural schematic diagram of a P-type silicon wafer, in which the P-type silicon wafer has been subjected to the single-sided texturing process but without removing the mask layer.
FIG. 6 is a structural schematic diagram of a P-type silicon wafer, in which the P-type silicon wafer has been subjected to the single-sided texturing process and the mask layer has been removed.
FIG. 7 is a structural schematic diagram of a P-type silicon wafer, in which the P-type silicon wafer has been subjected to a thermal oxidation process.
FIG. 8 is a bottom view of a P-type silicon wafer, in which the silicon oxide mask layer has been subjected to the patterning treatment.
FIG. 9 is a structural schematic diagram of a P-type silicon wafer, in which the P-type silicon wafer has been subjected to the etching process and the silicon oxide mask layer is removed.
FIG. 10 is a bottom view of a P-type silicon wafer, in which holes have been opened in the patterning region.

In the figures,
10 represents a P-type silicon wafer; 11 represents a first surface; 12 represents a second surface; 21 represents a oxide layer; 22 represents a doped amorphous silicon film layer; 23 represents a silicon oxide mask layer; 30 represents a doped polycrystalline silicon film layer; 40 represents a patterning region; 50 represents a passivating film layer; 60 represents a antireflection film layer; 70 represents an electrode contact region; 80 represents a first electrode; 90 represents a second electrode; and 100 represents a P-type back contact solar cell.

### DETAILED DESCRIPTION

In order to facilitate understanding of the present application, the application ill be described more fully below with reference to the relevant accompanying drawings. Preferred embodiments of the present application are given in the accompanying drawings. However, the present application can be realized in many different forms and is not limited to the embodiments described herein. It should be understood that these embodiments are provided to enable a more thorough and comprehensive understanding of the disclosure of the present application.

Furthermore, the terms "first" and "second" are used for descriptive purposes only and are not to be construed as indicating or implying relative importance or implicitly specifying the number or order of the indicated technical features. Thus, a feature defined with "first" or "second" may include at least one such feature, either explicitly or implicitly. In the description of the present application, "plurality" means at least two, e.g., two, three, etc., unless otherwise expressly and specifically limited.

In describing positional relationships, unless otherwise specified, when an element such as a layer, membrane, or substrate is referred to as being "on" another membrane layer, it can be directly on the other membrane layer or an intermediate membrane layer can also be present. Furthermore, when a layer is said to be "under" another layer, it may be directly underneath, or there may be one or more intermediate layers. It is also understood that when a layer is referred to as being "between" two layers, it may be the only layer between the two layers, or one or more intermediate layers may be present.

Unless mentioned to the contrary, terms in the singular form may include the plural form and are not to be understood as numbering one.

Unless otherwise defined, all technical and scientific terms used herein have the same meaning as commonly understood by those skilled in the art belonging to this application. The terms used herein in the specification of this application are used only for the purpose of describing specific embodiments and are not intended to limit this application.

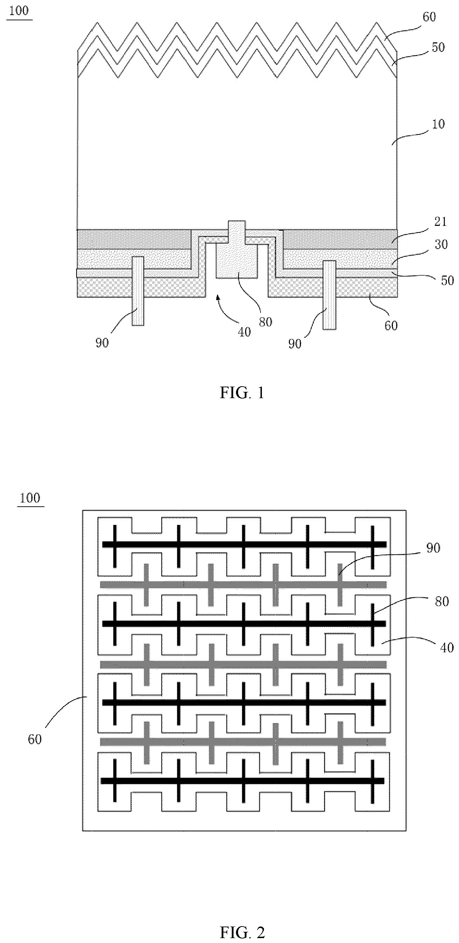

The present disclosure provides a method for manufacturing a P-type back contact solar cell 100. FIG. 1 and FIG. 2 are structural schematic diagrams of the P-type back contact solar cell 100. The method includes step S100 to step S800 shown hereinafter.

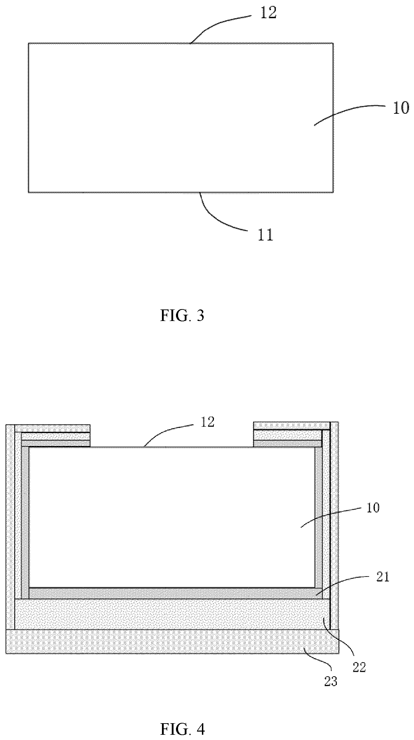

Step S100: providing a P-type silicon wafer 10, wherein the P-type silicon wafer 10 includes a first surface 11 and a second surface 12 opposite to the first surface 11. The structure of the P-type silicon wafer 10 is shown in FIG. 3.

In the first surface 11 and the second surface 12 of the P-type silicon wafer 10, one of the first surface 11 and the second surface 12 is an illuminated surface (i.e., a front surface) of the P-type back contact solar cell 100, the other surface of the first surface 11 and the second surface 12 is a shady surface (i.e., a back surface) of the P-type back contact solar cell 100. In some embodiments, the first surface 11 of the P-type silicon wafer 10 is regarded as the illuminated surface, and the second surface 12 of the P-type silicon wafer 10 is regarded as the shady surface, and the PN junction region and metal electrodes are disposed in the first surface 11 of the P-type silicon wafer 10.

In some embodiments, the P-type silicon wafer 10 is further subjected to a damage treatment, a polishing treatment and a cleaning treatment, so as to make the surface of the P-type silicon wafer 10 clean and smooth, thereby facilitating the following film-coating processes. The detailed processes includes the following steps: subjecting the surface of the P-type silicon wafer 10 to the damage treatment with a KOH solution at a temperature of about 60 °C; and subjecting the P-type silicon wafer 10 to the polishing treatment with a KOH solution at a temperature of about 75 °C, so as to make a surface reflectivity of the polished P-type silicon wafer 10 to reach 30%.

Step S200: sequentially depositing an oxide layer 21, a doped amorphous silicon film layer 22, and a silicon oxide mask layer 23 on the first surface 11 of the P-type silicon wafer 10.

The oxide layer 21, the doped amorphous silicon film layer 22 and the silicon oxide mask layer 23 are sequentially disposed outwardly on the first surface 11 of the P-type silicon wafer 10. The oxide layer 21 is an ultrathin silicon oxide film layer disposed tightly against the first surface 11 of the P-type silicon wafer, and a thickness of the oxide layer 21 is in a range of 0.5 nm to 2.5 nm. The doped amorphous silicon film layer 22 is a phosphour doped amorphous silicon film layer, and a thickness of the doped amorphous silicon film layer 22 is in a range of 30 nm to 300 nm, optionally the thickness of the doped amorphous silicon film layer 22 is in a range of 100 nm to 150 nm. A thickness of the silicon oxide mask layer 23 is in a range of 10 nm to 100 nm, optionally, the thickness of the silicon oxide mask layer 23 is in a range of 20 nm to 50 nm.

In some embodiments, the oxide layer 21, the doped amorphous silicon film layer 22 and the silicon oxide mask layer 23 are manufactured by a following method: growing the oxide layer 21 on the P-type silicon wafer 10 by a PECVD (Plasma Enhanced Chemical Vapor Deposition) method, a thermal oxidation method or a chain oxidationmehtod, and then sequentially growing the doped amorphous silicon film layer 22and the silicon oxide mask layer 23 on the oxide layer 21 by the PECVD method.

Step S300: subjecting the P-type silicon wafer 10 to a high temperature annealing process. The temperature of the annealing process is in a range of 800 °C to 950 °C, and a time of the annealing process is in a range of 30 min to 50 min. Due to the high temperature annealing process described above, the doped amorphous silicon film layer 22 is crystallized to form doped polycrystalline silicon; and the silicon oxide mask layer 23 is densified, so that the alkali resistance of the silicon oxide mask layer 23 is improved.

In the present disclosure, the doped amorphous silicon film layer 22 and the silicon oxide mask layer 23 are sequentially disposed on the oxide layer 21 by the plasma enhanced chemical vapor deposition method, and the P-type silicon wafer 10 is subjected to a heating and annealing process, so that the doped amorphous silicon film layer 22 is polycrystallized to form the doped polycrystalline silicon film layer 30, and make the silicon oxide mask layer 23 densified at the same time. Thus, alkali resistance of the silicon oxide mask layer 23 can be improved, protective effect of the silicon oxide mask layer 23 to the PN junction region in the following texturing process is improved, so as to prolong a time window of the following texturing process.

By independently manufacturing the silicon oxide mask layer 23 by the plasma enhanced chemical vapor deposition method, it is more conveniently to control the thickness of the silicon oxide mask layer 23. Due to deposition of the silicon oxide mask layer 23 is realized by reaction between an external silicon source gas (e.g., silane) and an external oxygen source gas (e.g., nitrous oxide), so that the mask layer having a suitable thickness can be prepared according to alkali resistance requirements.

Step S400: removing the oxide layer 21, the doped amorphous silicon film layer 22, and the silicon oxide mask layer 23 wraparound deposited on the second surface 12 of the P-type silicon wafer 10 with a mixed solution containing the hydrofluoric acid (HF) and the nitric acid (HNO₃).

In the manufacturing process of the back contact solar cell, whether the oxide layer 21, the doped amorphous silicon film layer 22 and the silicon oxide mask layer 23 is made by the PECVD method or the LPCVD method, it is unavoidable to wraparound deposit the oxide layer 21, the doped amorphous silicon film layer 22 and the silicon oxide mask layer 23 on a side surface of the cell and periphery edges of the second surface 12 (as shown in FIG. 4). Wraparound deposition of the oxide layer 21, the doped amorphous silicon film layer 22 and the silicon oxide mask layer 23 on the front surface of the cell may lead to surface texture nonuniformity of the illuminated surface and poor appearance of the illuminated surface of the cell after the texture process. The back contact cell is an appearance-type battery product, and a poor appearance of the illuminated surface will greatly affect the yield of the product. In addition, the surface texture nonuniformity of the illuminated surface will also lead to a high localized reflectivity of the front surface of the cell, which affects the cell current, and thus affects the efficiency of the cell.

In the present disclosure, after depositing the oxide layer 21, the doped amorphous silicon film layer 22 and the silicon oxide mask layer 23 on the P-type silicon wafer 10, the oxide layer 21, the doped amorphous silicon film layer 22 and the silicon oxide mask layer 23 wraparound deposited on the second surface 12 of the P-type silicon wafer 10 is removed with a mixed solution containing the hydrofluoric acid and the nitric acid, so as to ensure "surface states" uniformity of the second surface 12 before the texturing process, thereby ensuring surface texture uniformity of the second surface 12. That is, pyramids on the second surface 12 has the same characters such as sizes, heights, densities, and the like, so that the appearance of the front surface of the cell is improved; and thus, the cell efficiency and yield of the product are improved.

Specifically, the second surface 12 of the P-type silicon wafer 10 is subjected to a horizontal chain etching process with the mixed solution containing the hydrofluoric acid and the nitric acid. Firstly, a protective film (e.g., a water film) is covered on the first surface 11 of the P-type silicon wafer 10; then the second surface 12 is disposed downwards to contact an etching liquid (the mixed solution described above) brought out by a roller and perform the etching process, so as to remove the oxide layer 21, the doped amorphous silicon film layer 22 and the silicon oxide mask layer 23 wraparound deposited on the second surface 12. After the removing process, the P-type silicon wafer 10 is washed with water, neutralized with a weak base, washed with water again, washed with acid and dried. **In** this way, the oxide layer 21, the doped amorphous silicon film layer 22 and the silicon oxide mask layer 23 wraparound deposited on the second surface 12 are effectively removed, the surface texture uniformity of the front surface of the cell is improved, and the appearance of the front surface of the cell is improved.

**In** some embodiments, in the mixed solution containing the hydrofluoric acid and the nitric acid, a volume percentage of the hydrofluoric acid is in a range of 10% to 30%, and a volume percentage of the nitric acid is in a range of 50% to 80%. By applying the mixed solution having a such concentration, the oxide layer 21, the doped amorphous silicon film layer 22 and the silicon oxide mask layer 23 wraparound deposited on the second surface 12 can be effectively removed.

The nitric acid is not generally used in the manufacture of other types of cells to remove a wraparound deposition layer, primarily for the following reasons. **In** the manufacture of other types of cells, a pre-texture process is used. The wraparound deposition layer is attached on the texture structure of the other side (generally, a back surface of the silicon wafer, not the illuminated surface of the silicon wafer). Since the non-illuminated surface is plane and avoidance of electric leakage of the cell, the wraparound deposition layer and the texture surface of the non-illuminated surface should be removed together. Thus, an etching depth is generally thick, and is about 3 µm. A consumption amount of nitric acid is great if nitric acid is used to remove the wraparound deposition layer, and the cost is great. In the present disclosure, however, a post-texturing process is used in the method for manufacturing the back contact solar cell, the second surface 12 is not textured, and a thickness of the wraparound deposition layer is generally about 300 nm. Thus, a consumption amount of the nitric acid is small, and a concentration of the nitric acid can be further lowered, which facilitate lowering the cost. The mixed solution containing the hydrofluoric acid and the nitric acid is used to remove the wraparound deposition layer. The nitric acid has a strong oxidizing property, and can react with silicon to generate silicon oxide. The hydrofluoric acid can remove the generated silicon oxide and play a role of polishing.

Specifically, a mass percentage of the hydrofluoric acid solution is 49%, and the mass percentage of the nitric acid is 69%. A volume ratio of water, the hydrofluoric acid and the nitric acid can be 1 : 2 : 7. In the etching liquid, the consumption amount of the nitric acid can be lowered by adding concentrated sulfuric acid, and uniformity of etching can be improved at the same time. A volume percentage of the sulfuric acid can be controlled in a range of 10% to 25%, and a mass percentage of the sulfuric acid can be 69%. A volume ratio of water, the hydrofluoric acid, the nitric acid and the concentrated sulfuric acid can be 1 : 2 : 6 : 1. The nitric acid and the concentrated sulfuric acid can play a role of oxidation, and the hydrofluoric acid can play a role of etching (reacting with the silicon oxide).

In the process of depositing the oxide layer 21, the doped amorphous silicon film layer 22 and the silicon oxide mask layer 23 on the first surface 11 of the P-type silicon wafer 10, the oxide layer 21, the doped amorphous silicon film layer 22 and the silicon oxide mask layer 23 are unavoidably wraparound deposited on the side surface of the P-type silicon wafer 10, and thus the performance of the battery is affected. In the present disclosure, after further depositing the oxide layer 21, the doped amorphous silicon film layer 22 and the silicon oxide mask layer 23 on the first surface 11 of the P-type silicon wafer 10, the oxide layer 21, the doped amorphous silicon film layer 22 and the silicon oxide mask layer 23 wraparound deposited on the side surface of the P-type silicon wafer 10 is removed with the mixed solution containing the hydrofluoric acid and the nitric acid. The detailed method for removing the oxide layer 21, the doped amorphous silicon film layer 22 and the silicon oxide mask layer 23 wraparound deposited on the side surface of the P-type silicon wafer 10 can be similar to the method for removing the oxide layer 21, the doped amorphous silicon film layer 22 and the silicon oxide mask layer 23 wraparound deposited on the second surface 12.

Step S500: single-sided texturing the second surface 12 of the P-type silicon wafer 10.

A texturing liquid used in a slot type single-sided texturing process is an alkali solution containing a single-sided texturing additive. The alkali solution is a strong monobasic alkali solution, such as a NaOH solution. A volume percentage of the alkali solution is in a range of 1% to 3%, and a temperature of the soaking and texturing process is in a range of 60 °C to 85 °C, and a time of the soaking and texturing process is in a range of 300 s to 550 s. Organic groups in the single-sided texturing additive can be absorbed on the first surface 11 of the silicon oxide mask layer 23 to form obstruction, so as to protect the non-texturing surface (the first surface 11) and accomplish the single-sided texturing. The single-sided texturing additive can be purchased from the market. A volume percentage of the single-sided texturing additive in the basic solution is in a range of 0.5% to 1.5%.

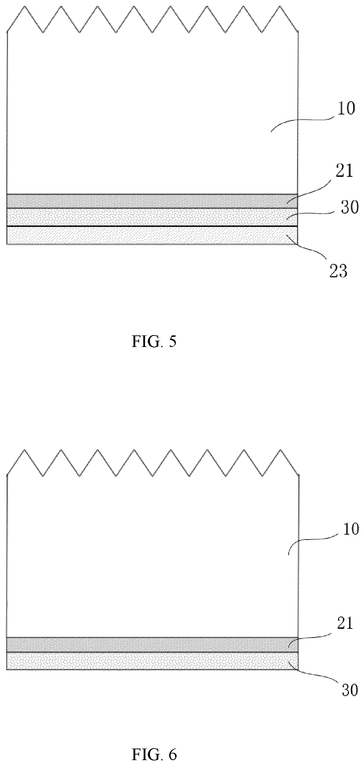

By single-sided texturing process, pyramid-shaped texture surface can be formed on the front surface (second surface 12). A height of the pyramid is in a range of 0.5 µm to 3 µm. After the texturing process, the sample is washed with an alkali solution, washed with deionized water, washed with an acid solution, washed with deionized water, and finally dried. If an acid solution without the hydrofluoric acid (e.g., hydrochloric acid) is used in the process of washing with acid, the silicon oxide mask layer 23 on the first surface 11 can be retained (as shown in FIG. 5). If an acid solution containing the hydrofluoric acid is used in the process of washing with acid, the silicon oxide mask layer 23 on the first surface 11 will not retain, and the silicon oxide mask layer 23 is removed by the hydrofluoric acid (as shown in FIG. 6).

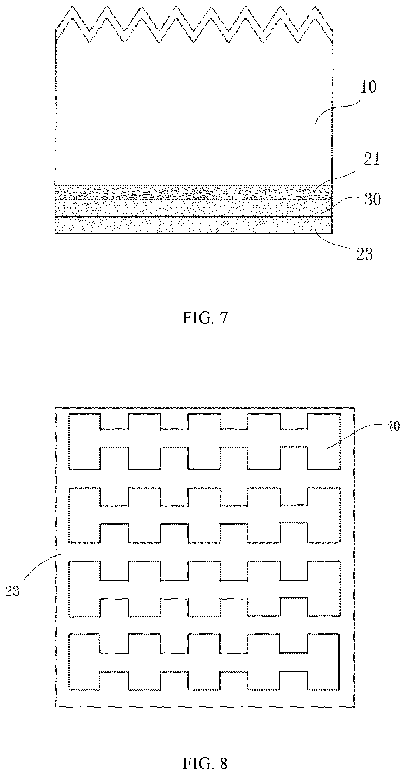

Step S600: subjecting the second surface 12 to thermal oxidation. A temperature of the thermal oxidation process is in a range of 700 °C to 900 °C, and a time of the thermal oxidation process is in a range of 10 min to 40 min. The aim of the thermal oxidation process is to form silicon oxide on the second surface 12. The silicon oxide formed by the thermal oxidation process can protect the surface texture structure of the second surface 12, so that the surface texture structure will not be damaged in the following etching process or polishing process. A thickness of the generated silicon oxide is in a range of 1 nm to 10 nm. If the acid solution used in step S500 contains the hydrofluoric acid, the thermal oxidation in step S600 is double-sided oxidation. If the acid solution used in step S500 does not contain the hydrofluoric acid, the thermal oxidation in step S600 is merely operated on the second surface 12 (as shown in FIG.7, the film on the texture surface of the second surface 12 is the silicon oxide formed after the thermal oxidation process).

Step S700: subjecting the silicon oxide mask layer 23 on the first surface 11 of the P-type silicon wafer 10 to a patterning treatment by laser, so as to remove a part of the silicon oxide mask layer 23 to form a patterning region 40. The structure after the patterning treatment is shown in FIG. 8.

In the present disclosure, after the thermal oxidation process, the silicon oxide mask layer 23 on the first surface 11 of the P-type silicon wafer 10 is subjected to to a patterning treatment by laser, so as to remove a part of the silicon oxide mask layer 23 to form the patterning region 40. The patterning region 40 is configured for manufacturing an electrode directly connected to the P-type silicon wafer 10. A width of the patterning region 40 is in a range of 300 µm to 500 µm.

Step S800: etching the doped polycrystalline silicon film layer 30 and the oxide layer 21 in the patterning region 40.

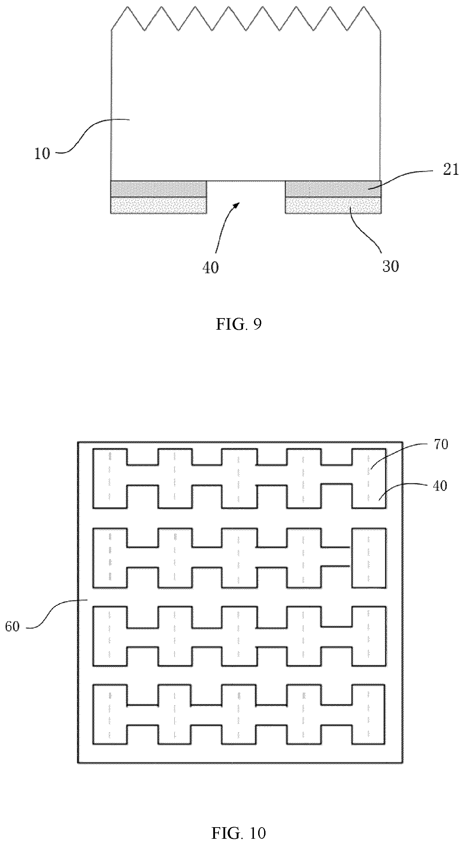

The cell after the patterning treatment was subjected to a soaking and etching process in a slot. The front surface of the cell is protected by silicon oxide, and the N-type region on the back surface of the cell is protected by silicon oxide. The patterning region 40 on the back surface has been treated with laser (silicon oxide is gasified by laser and silicon at high temperature, or integrity of covalent bonds in the silicon oxide is damaged by laser), and becomes easy to be etched. The etching liquid mainly includes a monobasic alkali, such as NaOH, and a volume percentage of the monobasic alkali is generally in a range of 3% to 10%. The etching liquid further includes a polishing additive purchased from the market, and a volume percentage of the polishing additive is in a range of 0.5% to 2%. The temperature of the etching process is in a range of 50 °C to 85 °C, and a time of the etching process is in a range of 200 s to 500 s. The sample after the etching process is washed with an alkali solution, washed with deionized water, washed with an acid solution (containing the hydrofluoric acid, so as to remove the silicon oxide mask layer 23 on the front surface and N-type region of the back surface), washed with deionized water and dried. The structure after the etching process is shown in FIG. 9.

Step S900: depositing passivating film layers 50 on the first surface 11 of the P-type silicon wafer 10 and the second surface 12 of the P-type silicon wafer 10, respectively; and then depositing antireflection film layers 60 on the first surface 11 of the P-type silicon wafer 10 and the second surface 12 of the P-type silicon wafer 10, respectively. The passivating film layers 50 play a role of passivation, and the antireflection film layers 60 play a role of reducing reflectivity of the cell.

In some embodiments, the passivating film layer 50 is an aluminum oxide layer generated by an ALD (atomic layer deposition) method. A thickness of the passivating film layer 50 is in a range of 2 nm to 25 nm. The antireflection film layer 60 is made of materials selected from the group consisting of silicon nitride, silicon nitride oxide, silicon oxide, and any combinations thereof, and a thickness of the antireflection film layer 60 is in a range of 50 nm to 150 nm.

Step S100: forming holes in the patterning region 40 on the first surface 11 of the P-type silicon wafer 10 by laser, so as to remove the passivating film layer 50 and the antireflection film layer 60 at the holes to form an electrode contact region 70; forming holes on the first surface 11 of the P-type silicon wafer 10 except for in the patterning region 40 by laser, so as to remove the passivating film layer 50 and the antireflection film layer 60 at the holes; and then filling electrode slurry in the electrode contact region 70 and the doped polycrystalline silicon film layer 30 to form the first electrode 80 and the second electrode 90, respectively. The structure of the patterning region 40 after the holes have been formed is shown in FIG. 10.

In the process of forming holes, only the protective film of the localized contact portion under subgrids of the patterning region 40 is required to be broken, and the protective film of the N-type region (the region except for the patterning region 40) is not required to be broken. It is because a slurry of the first electrode 80 is generally a non-burnthrough slurry, i.e., the slurry of the first electrode 80 will not burn through the passivating film layer 50 and the antireflection film layer 60; and, the slurry of the N-type region is a burnthrough slurry.

The first electrode 80 is directly connected to the P-type silicon wafer 10, and the second electrode 90 is directly connected to the doped polycrystalline silicon film layer 30, which is the region except for the patterning region 40 on the first surface 11. In some embodiments, the first electrode 80 is an aluminum grid line electrode, and a width of the first electrode 80 is in a range of 50 µm to 200 µm; and the second electrode 90 is a silver grid line electrode, and a width of the second electrode 90 is in a range of 10 µm to 50 µm.

Specifically, in the process of forming holes in the patterning region 40 by laser, the holes are disposed in dotted lines or punctuation. A width of the holes is in a range of 30 µm to 50 µm, i.e., a width of the electrode contact region 70 is in a range of 30 µm to 50 µm. A electrode slurry layer containing conductive components can be formed in the electrode contact region 70 by means of silk-screen printing. And the electrode slurry layer can be regarded as the first electrode 80 and the second electrode 90, respectively.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present application.

Those of ordinary skill in the art should realize that the above embodiments are only used to illustrate the present application and are not intended to be used as a limitation of the present application. As long as appropriate changes and variations to the above embodiments are made within the scope of the present application within the spirit and substance of the present application, they fall within the scope of the claimed protection of the present application.

## Claims

1. A method for manufacturing a solar cell, comprising the following steps:
providing a P-type silicon wafer, wherein the P-type silicon wafer comprises a first surface and a second surface opposite to the first surface;
sequentially depositing an oxide layer, a doped amorphous silicon film layer, and a silicon oxide mask layer on the first surface of the P-type silicon wafer; and
removing the oxide layer, the doped amorphous silicon film layer, and the silicon oxide mask layer wraparound deposited on the second surface of the P-type silicon wafer.

2. The method of claim 1, wherein the step of removing the oxide layer, the doped amorphous silicon film layer, and the silicon oxide mask layer wraparound deposited on the second surface of the P-type silicon wafer further comprises: removing the oxide layer, the doped amorphous silicon film layer, and the silicon oxide mask layer wraparound deposited on the second surface of the P-type silicon wafer by a mixed solution containing hydrofluoric acid and nitric acid.

3. The method of claims 1 or 2, wherein the step of removing the oxide layer, the doped amorphous silicon film layer, and the silicon oxide mask layer wraparound deposited on the second surface of the P-type silicon wafer further comprises the following steps:
coating a protective film on the first surface of the P-type silicon wafer, and
etching the second surface of the P-type silicon wafer with the mixed solution containing the hydrofluoric acid and the nitric acid, so as to remove the oxide layer, the doped amorphous silicon film layer, and the silicon oxide mask layer wraparound deposited on the second surface of the P-type silicon wafer.

4. The method of claims 2 or 3, wherein in the mixed solution containing the hydrofluoric acid and the nitric acid, a volume percentage of the hydrofluoric acid is in a range of 10% to 30%, and a volume percentage of the nitric acid is in a range of 50% to 80%.

5. The method of any one of claims 2 to 4, wherein the mixed solution containing the hydrofluoric acid and the nitric acid further comprises a sulfuric acid, and a volume percentage of the sulfuric acid is in a range of 10% to 25%.

6. The method of any one of claims 1 to 5, wherein depositing the oxide layer on the first surface of the P-type silicon wafer further comprises: depositing the oxide layer on the first surface of the P-type silicon wafer by a plasma enhanced chemical vapor deposition method, a thermal oxidation method or a chain oxidation method.

7. The method of any one of claims 1 to 6, wherein depositing the doped amorphous silicon film layer and the silicon oxide mask layer on the first surface of the P-type silicon wafer further comprises: depositing the doped amorphous silicon film layer and the silicon oxide mask layer on the first surface of the P-type silicon wafer by a plasma enhanced chemical vapor deposition method.

8. The method of any one of claims 1 to 7, wherein the manufacturing method meets at least one of (1) to (4) hereinafter,
(1) the oxide layer is a silicon oxide layer;
(2) a thickness of the oxide layer is in a range of 0.5 nm to 2.5 nm;
(3) a thickness of the doped amorphous silicon film layer is in a range of 30 nm to 300 nm; and
(4) a thickness of the silicon oxide mask layer is in a range of 10 nm to 100nm.

9. The method of any one of claims 1 to 8, wherein after the step of depositing the silicon oxide mask layer, and before the step of removing the oxide layer, the doped amorphous silicon film layer and the silicon oxide mask layer wraparound deposited on the second surface of the P-type silicon wafer, the manufacturing method further comprises a step of subjecting the P-type silicon wafer to an annealing process, so as to transform the doped amorphous silicon film layer to a doped polycrystalline silicon film layer and make the silicon oxide mask layer densified.

10. The method of claim 9, wherein a temperature of the annealing process is in a range of 800 °C to 950 °C, and a time of the annealing process is in a range of 30 min to 50 min.

11. The method of any one of claims 1 to 10, wherein after the step of removing the oxide layer, the doped amorphous silicon film layer, and the silicon oxide mask layer wraparound deposited on the second surface of the P-type silicon wafer, the manufacturing method further comprises a step of single-sided texturing the second surface of the P-type silicon wafer.

12. The method of claim 11, wherein after the step of single-sided texturing the second surface of the P-type silicon wafer, the manufacturing method further comprises a step of subjecting the second surface of the P-type silicon wafer to a thermal oxidation process.

13. The method of claim 12, wherein after subjecting the second surface of the P-type silicon wafer to the thermal oxidation process, the manufacturing method further comprises a following step:
subjecting the silicon oxide mask layer on the first surface of the P-type silicon wafer to a patterning treatment by laser, so as to remove a part of the silicon oxide mask layer to form a patterning region.

14. The method of claim 13, wherein after forming the patterning region, the manufacturing method further comprises a following step:
etching the P-type silicon wafer with an alkali solution, so as to remove the oxide layer and the doped polycrystalline silicon film layer in the patterning region.

15. The method of claim 14, wherein after the etching the P-type silicon wafer with the alkali solution, the manufacturing method further comprises: depositing passivating film layers on the first surface of the P-type silicon wafer and the second surface of the P-type silicon wafer, respectively.

16. The method of claim 15, wherein the passivating film layers are aluminum oxide layers and thicknesses of the passivating film layers are in a range of 2 nm to 25 nm.

17. The method of claims 15 or 16, wherein after depositing the passivating film layers on the first surface of the P-type silicon wafer and the second surface of the P-type silicon wafer respectively, the manufacturing method further comprises a step of depositing antireflection film layers on the first surface of the P-type silicon wafer and the second surface of the P-type silicon wafer, respectively.

18. The method of claim 17, wherein the antireflection film layers are made of materials selected from the group consisting of silicon nitride, silicon nitride oxide, silicon oxide, and any combinations thereof, and thicknesses of the antireflection film layers are in a range of 50 nm to 150 nm.

19. The method of claims 17 or 18, wherein after the step of depositing the antireflection film layers on the first surface of the P-type silicon wafer and the second surface of the P-type silicon wafer respectively, the manufacturing method further comprises following steps:
forming holes in the patterning region on the first surface of the P-type silicon wafer by laser, so as to remove the passivating film layer and the antireflection film layer at the holes to form an electrode contact region; and
filling electrode slurry in the electrode contact region and the doped polycrystalline silicon film layer to form the first electrode and the second electrode, respectively.

20. A solar cell manufactured by the method of any one of claims 1 to 19.
